Europäisches Patentamt

European Patent Office

Office européen des brevets

(11) Publication number: **0 148 520**
**B1**

# EUROPEAN PATENT SPECIFICATION

(45) Date of publication of patent specification: **28.09.88**

(51) Int. Cl.⁴: **H 03 B 5/12, H 03 L 5/00**

(21) Application number: **84201721.2**

(22) Date of filing: **26.11.84**

(54) Oscillator circuit.

(30) Priority: **29.11.83 NL 8304085**

(43) Date of publication of application:
**17.07.85 Bulletin 85/29**

(45) Publication of the grant of the patent:
**28.09.88 Bulletin 88/39**

(84) Designated Contracting States:
**DE FR GB IT NL**

(56) References cited:
**BE-A- 645 253**
**US-A-3 555 303**
**US-A-3 649 929**

(73) Proprietor: **N.V. Philips' Gloeilampenfabrieken**
**Groenewoudseweg 1**
**NL-5621 BA Eindhoven (NL)**

(72) Inventor: **Nordholt, Ernst Hugo**
**c/o INT. OCTROOIBUREAU B.V. Prof. Holstlaan 6**
**NL-5656 AA Eindhoven (NL)**
Inventor: **Boon, Cornelis Alexander Maria**
**c/o INT. OCTROOIBUREAU B.V. Prof. Holstlaan 6**
**NL-5656 AA Eindhoven (NL)**

(74) Representative: **Schoonheijm, Harry Barend**
**et al**
**INTERNATIONAAL OCTROOIBUREAU B.V.**
**Prof.Holstlaan 6**
**NL-5656 AA Eindhoven (NL)**

Courier Press, Leamington Spa, England.

## Description

The invention relates to an oscillator circuit comprising first and second transistors whose emitters are intercoupled and jointly connected to the collector of a third transistor, the first transistor being connected in a grounded base connection delivering a circuit voltage across a parallel reasonant circuit coupled to the collector of the first transistor, the collector being coupled to the base of the second transistor for a regenerative feedback of the circuit voltage.

Such an oscillator circuit is described in US—A—3,649,929.

When the prior art oscillator circuits are produced in larger quantites, the individual circuits may mutually show spread in the amplitude of the oscillator eoutput signal. for example due to inaccuracies in the values of the circuit elements. In addition, the oscillator amplitude may vary due to *inter alia* temperature fluctuations or ageing.

In order to keep the oscillator amplitude i.e. the amplitude of said circuit voltage at a constant value the known oscillator circuit comprises an AGC-circuit for reducing the gain of the transistors when the oscillator amplitude increases and vice versa. In said AGC-circuit the amplitude of the circuit voltage is detected and converted into a DC-gain control signal, which is applied to the base of the third transistor. However, for a proper amplitude detection the known oscillator circuit needs a comparatively large capacitance and is therefore not so suitable for integration. In addition the amplitude detection when used in an oscillator circuit introduces a certain degree of control inertia, which may result in unwanted transients.

The invention has for its object to provide an oscillator circuit comprising a simple stabilizing circuit, which can be easily integrated and stabilizes the oscillator amplitude at a predetermined value without any noticeable delay and highly independent of the spread in values of the resonant circuit elements.

According to the invention, an oscillator circuit of the type described in the opening paragraph is characterized in that the collector of the first transistor is AC-coupled to the base of the third transistor for a negative feedback of the circuit voltage.

The invention is based on the recognition that a negative feedback of the circuit voltage, when properly dimensioned, does not deteriorate the regenerative feedback required for oscillation and provides the possibility to stabilize the oscillator amplitude without amplitude detection.

By applying the measure according to the invention an increase or decrease respectively of the collector current of the third transistor instantaneous coincides with a decrease or increase, respectively in the conduction of the first transistor. If the oscillator amplitude increases, for example as a result of the abovementioned ambient factors, then also the collector current of the third transistor increases, which for a suitably chosen transistor setting results in an instantaneous decrease of the collector current of the first transistor applied to the resonant circuit. The reverse holds for the case in which the oscillator amplitude decreases.

Although the collector current of the second transistor varies in the same phase as the oscillator signal this does not have any effect on the circuit voltage as the second transistor only functions as an emitter follower and its collector current flows to ground without passing through the resonant circuit.

A preferred embodiment of the oscillator circuit according to the invention is characterized by a fourth transistor, whose base is connected to a fixed base biasing voltage and whose emitter is coupled to the emitter of the third transistor, both emitters being jointly connected to a constant current source, the current thereof at the biasing voltages of the third and fourth transistors flowing to a sufficient extent through the third transistor for amplifying the circuit voltage in the first transistor, such that regeneration the circuit voltage taking place.

When this measure is applied, the emitter currents of the first and second transistors vary more than linear with the circuit voltage, which is fedback to the base of the third transistor, as a result of which the influence of the resonant circuit quality on the amplitude of the circuit voltage decreases still further.

Another preferred embodiment of the oscillator circuit according to the invention is characterized in that the collector of the first transistor is coupled *via* an emitter follower to a first voltage divider a first output of which is AC-connected to the base of the second transistor and a second output to the base of the third transistor and in that a second voltage divider is arranged between a supply voltage and ground a first output thereof being coupled to the base of the first transistor and a second output to the base of the fourth transistor.

When this measure is applied an adequate setting of on the one hand a sufficiently strong positive feedback to maintain an oscillation and on the other hand a sufficiently strong negative feedback for an acceptable stabilization of the oscillator amplitude can be obtained in a simple way.

The invention will now be described in greater detail by way of example with reference to the Figures in the accompanying drawing

Therein:

Figure 1 shows an oscillator circuit according to the invention;

Figures 2A—2D show the voltage and time-dependent variations, respectively of the current of the variable current source used in the oscillator circuit of Figure 1 and the voltage and time-dependent variations of the current applied to the reasonant circuit.

Figures 3A—3C show the voltage and time dependent variations, respectively of the current of a different embodiment of the variable current source and that of the current applied to the resonant circuit.

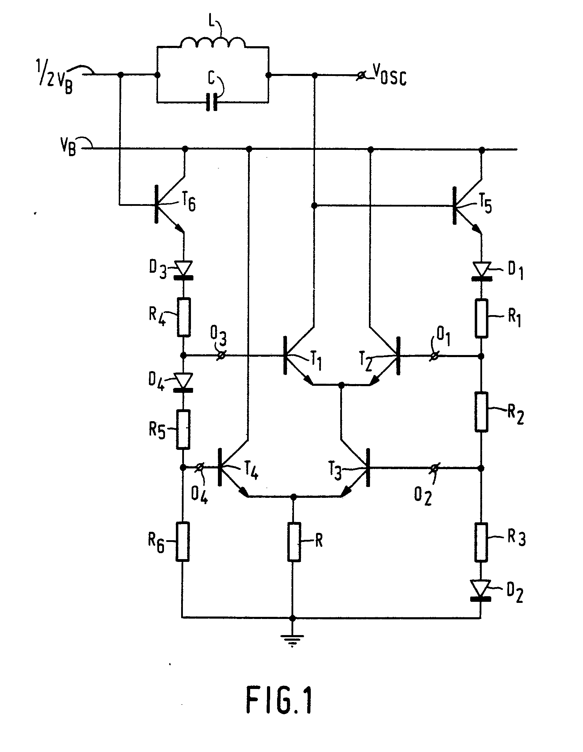

Figure 1 shows an oscillator circuit according to the invention comprising first and second emitter-coupled transistors $T_1$ and $T_2$, respectively with a variable current source $T_3$, $T_4$, R included in a common emitter path. The current source $T_3$, $T_4$, R comprises third and fourth emitter-coupled transistors $T_3$ and $R_4$, respectively with a high ohmic resistor R included in a common emitter path and acting as a constant current source. The collector of the third transistor $T_3$ is connected to the coupled emitters of the first and second transistors $T_1$ and $T_2$. The base of this third transistor $T_3$ constitutes a control input of the variable current source $T_3$, $T_4$, R.

The base biassing of said transistor $T_1$—$T_4$ are obtained by d.c. coupling from a supply voltage $1/2\,V_B$ via emitter followers $T_5$ and $T_6$ and first and second voltage dividers $D_1$, $D_2$, $R_1$—$R_3$ and $D_3$, $D_4$, $R_4$—$R_6$. In this situation the collectors of the two emitter followers $T_5$ and $T_6$ are connected to a supply voltages $V_B$. This first voltage divider $D_1$, $D_2$, $R_1$—$R_3$ comprises, arranged between the emitter output of the emitter follower $T_5$ and ground, a series arrangement of, in succession, a diode $D_1$, three resistors $R_1$—$R_3$ and a diode $D_2$, which has a first output $D_1$ located at the junction between the resistors $R_1$ and $R_2$ and connected to the base of the second transistor $T_2$ and a second output $O_2$ located at the junction between the transistors $R_2$ and $R_3$ and connected to the base of the third transistor $T_3$. The second voltage divider $D_3$, $D_4$, $R_4$—$R_6$ comprises, arranged between the emitter output of the emitter follower $T_6$ and ground, a series arrangement of, in succession, a diode $D_3$, a resistor $R_4$, a diode $D_4$ and two resistors $R_5$ and $R_6$, which has a first output $O_3$ located at the junction between the resistor $R_4$ and the diode $D_4$ and connected to the base of the first transistor $T_1$ and a second output $O_4$ at the junction between the resistors $R_5$ and $R_6$ and connected to the base of the fourth transistor $T_4$.

The resistors $R_1$ and $R_4$; $R_2$ and $R_5$; $R_3$ and $R_6$ have mutually identical values, as have also the diodes $D_1$—$D_4$, so that the base biassing voltages of the first and second transistors $T_1$ and $T_2$ are mutually the same, whilst the base biassing voltage of the third transistor $T_3$ is located one diode voltage step higher than the base biassing voltage of the fourth transistor $T_4$. As a result thereof, in the rest position, the third transistor $T_3$ is in a conducting state and the fourth transistor $T_4$ is non-conductive, whilst the first and second transistors $T_1$ and $T_2$ are mutually in balance. The collectors of the second and fourth transistors $T_2$ and $T_4$ are connected to the supply voltage $V_B$ and therewith connected to earth for RF, so that these transistors are arranged in a grounded-collector connection. The base of the emitter follower $T_6$ is connected to the supply voltage $\frac{1}{2}V_B$ and therewith connected to earth for RF, so that the first transistor $T_1$ is arranged to a grounded-base connection. The collector of the first transistor $T_1$ is connected via a parallel LC-resonant circuit to the

supply voltage $\frac{1}{2}V_B$ and constitutes an output $V_{osc}$ of the oscillator circuit. This collector is connected to the base of the emitter follower $T_5$, as a result of which the voltage across the resonant circuit LC or co called circuit voltage is positively fedback to the base of the second transistor $T_2$ via this emitter follower $T_5$ and the first voltage divider $D_1$, $D_2$, $R_1$—$R_3$. The second transistor $T_2$ forms together with the first transistor $T_1$ a switching differential amplifier $T_1$. $T_2$ whose output voltage at the collector of $T_1$ is in phase with the input voltage at the base of $T_2$. This output voltage is at its maximum at the resonant frequency of the LC-resonant circuit, so that in a manner which is known per se at an adequate gain of the differential amplifier $T_1$, $T_2$, that is to say at a sufficeintly large collector current of $T_3$ a loop gain equal to unity for said resonant frequency is reached and a spontaneous oscillator is effected from a rest or initial condition.

The amplitude of the circuit voltage, i.e. the oscillator amplitude depends on the quality factor of the LC-resonant circuit and the magnitude of the collector current of $T_1$ applied to this circuit. An instantaneous stabilization of the circuit voltage is obtained by modulating said collector current in anti-phase by the circuit voltage, that is to say by reducing the collector current instantaneously at an increasing circuit voltage and vice versa. By increasing the circuit voltage-dependent collector current variation the stabilization can be improved.

In the embodiment shown such a modulation of the collector current of $T_1$ is obtained because that portion of the circuit voltage being applied to the base of $T_3$ is in-phase with the circuit voltage portion applied to the base of $T_2$. As, in addition, the transistors $T_1$ and $T_2$ switch alternately and in mutual phase opposition from the conductive to the non-conductive state, the collector current of the first transistor $T_1$, when conducting, corresponds to the collector current of the third transistor $T_3$.

The third transistor $T_3$ forms, together with the fourth transistor $T_4$ a differential amplifier $T_3$, $T_4$, which in certain circumstances acts as a current limiter and whose output current varies in a highly non-linear way with the input voltage. The base biassing voltage of $T_3$ is one diode voltage step higher than the base biassing voltage of $T_4$, as a result of which mn the one hand, as mentioned above, a spontaneous oscillation from the rest or initial condition is possible and on the other hand the range in which the collector current of $T_3$ has its maximum variation versus the base voltage and in which circuit voltage amplitude deviations are negatively fedback to the highest degree, has been set advantageously for the chosen use of the oscillator circuit.

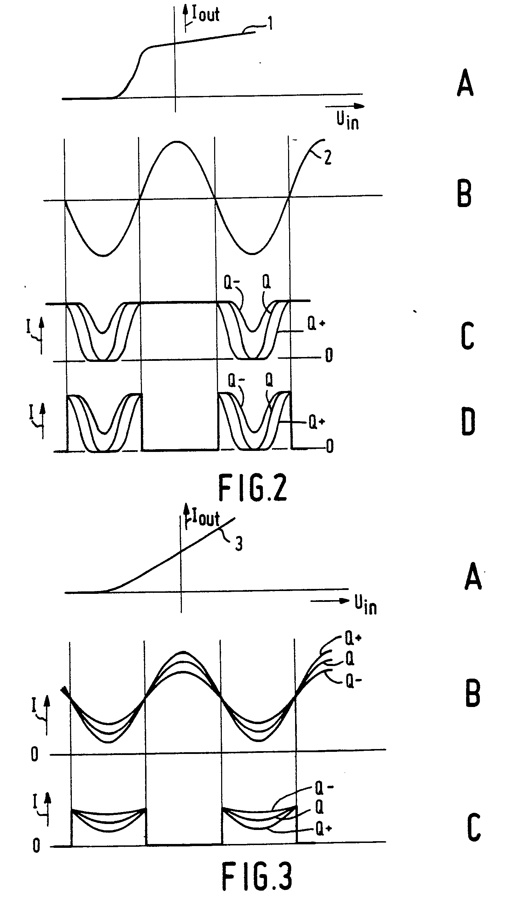

Then the collector current of the third transistor $T_3$ varies in dependence on the base input voltage as illustrated in Figure 2A by means of curve 1. Starting from a certain standardized value Q for the quality factor of the LC-resonant circuit, a sinusoidal circuit voltage having a given desired amplitude whose variation is illustrated in Figure 2B by means of curve 2, was obtained. The variation of the collector current of the third transistor $T_3$ and the variation of the first transistor $T_1$ are illustrated by means of the respective curves $Q$ in Figures 2C and 2D, respectively. A reduction of the circuit voltage, for example due to a variation of the tuning of the LC-resonant circuit becasue of the use of an LC-resonant circuit having a lower quality factor $Q_-$ or due to ambient factors result in variations of the collector currents of $T_3$ and $T_1$ as illustrated by the respective curves $Q_-$ in Figure 2B and Figure 2C, respectively, in response thereto and average collector current of $T_1$ increases instantaneously, so that the circuit voltage also increases instantaneously to the desired standardized value. The opposite situation is obtained when the circuit voltage is increased; the collector currents of $T_3$ and $T_1$, respectively varies as illustrated by curves $Q_+$ in Figures 2B and 2C, respectively. Then the average collector current from $T_1$ to the circuit decreases instantaneously, so that also the circuit voltage decreases instantaneously to the desired standardized value. In said practical embodiment the resistors had the following values:

$R_1$ and $R_4$: 200 $\Omega$

$R_2$ and $R_5$: 700 $\Omega$

$R_3$, $R_6$ and R: 1 K$\Omega$.

The LC-resonant.circuit was tunable between 10 and 17 MHz and had a quality factor varying between 30 and 50. Also larger variations of the quality factor, for example between 10 and 130 had hardly any noticeable influence on the oscillator amplitude, thanks to the stabilizing action of the oscillator circuit according to the invention.

It will be obvious that the invention is not limited to the embodiment shown. Thus, it is alternatively possible to omit the fourth transistor $T_4$ and to use only the third transistor $T_3$ with the resistor R as the variable current source for the differential amplifier $T_1$, $T_2$. The collector current of the third transistor $T_3$ then varies linearly versus the base voltage, as illustrated in Figure 3A by means of curve 3. Starting from a circuit voltage varying as shown in Figure 2B by means of curve 2, the collector current of $T_3$ and $T_1$, respectively varies as shown in the respective Figures 3B and 3C for the desired standardized value of the circuit voltage amplitude in accordance with curve $Q$ for a certain increase in the circuit voltage amplitude in accordance with the curve $Q_+$ and for a certain decrease in accordance with the curve $Q_-$.

It should be noted that for a person skilled in the art it will not be difficult to apply the inventive idea to circuits of different types, which in essence function in the same way as the circuit shown and by using, for example, a non-switching differential amplifier $T_1$, $T_2$. It will further be obvious that the word "transistor" also includes field effect transistors, of which, as is known, the gate, source and drain electrodes, respectively correspond to the base, collector and emitter electrodes of bipolar transistors, used in this description.

**Claims**

1. An oscillator circuit comprising first and second transistors ($T_1$, $T_2$) whose emitters are intercoupled and jointly connected to the collector of a third transistor ($T_3$), the first transistor ($T_1$) being connected in a grounded base connection delivering a circuit voltage across a parallel reasonant circuit (LC) coupled to the collector of the first transistor ($T_1$), the collector being coupled to the base of the second transistor ($T_2$) for a regenerative feedback of the circuit voltage, characterized in that the collector of the first transistor ($T_1$) is AC-coupled to the base of the third transistor ($T_3$) for a negative feedback of the circuit voltage.

2. An oscillator circuit as claimed in Claim 1, characterized by a fourth transistor ($T_4$), whose base is connected to a fixed base biassing voltage and whose emitter is coupled to the emitter of the third transistor ($T_3$), both emitters being jointly connected to a constant current source, the current thereof at the biassing voltages of the third and fourth transistors ($T_3$, $T_4$) flowing to a sufficient extent through the third transistor ($T_3$) for amplifying the circuit voltage in the first transistor ($T_1$), such that regeneration of the circuit voltage taking place.

3. An oscillator circuit as claimed in Claim 2, characterized in that the collector of the first transistor is coupled *via* an emitter follower ($T_5$) to a first voltage divider ($D_1$, $D_2$, $R_1$—$R_3$) a first output ($O_1$) of which is AC-connected to the base of the second transistor ($T_2$) and a second output ($O_2$) to the base of the third transistor ($T_3$) and in that a second voltage divider ($D_3$, $D_4$, $R_4$—$R_6$) is arranged between a supply voltage ($\frac{1}{2}V_B$) and ground, a first output ($O_3$) thereof being coupled to the base of the first transistor ($T_1$) and a second output ($O_4$) to the base of the fourth transistor ($T_4$).

**Patentansprüche**

1. Oszillatorschaltung mit ersten und zweiten Transistoren ($T_1$, $T_2$), deren Emitterelektroden miteinander sowie mit dem Kollektor eines dritten Transistors ($T_3$) verbunden sind, wobei der erste Transistor ($T_1$) in basisgeerdeter Schaltung geschaltet ist, die an einem mit dem Kollektor des ersten Transistors ($T_1$) gekoppelten Parallel-Resonanzkreis (LC) eine Kreisspannung liefert, wobei dieser Kollektor zur regenerativen Rückkopplung der Kreisspannung mit der Basis des zweiten Transistors ($T_2$) gekoppelt ist, dadurch gekennzeichnet, dass der Kollektor des ersten Transistors ($T_1$) zur negativen Rückkopplung der Kreisspannung wechselstrommässig mit der Basis des dritten Transistors ($T_3$) gekoppelt ist.

2. Oszillatorschaltung nach Anspruch 1, gekennzeichnet durch einen vierten Transistor ($T_4$), dessen Basis mit einer festen Basiseinstellspannung versehen ist und dessen Emitter mit dem Emitter des dritten Transistors ($T_3$) verbunden ist, wobei die beiden Emitterelektroden gemeinsam mit einer Quelle konstanten Stromes verbunden sind, wobei dieser Strom bei der Einstellspannung des dritten und vierten Transistors ($T_3$, $T_4$) in ausreichenden Masse durch den dritten Transistor ($T_3$) fliesst um die Kreisspannung in dem ersten Transistor ($T_1$) derart zu verstärken, dass Regeneration der Kreisspanung auftritt.

3. Oszillatorschaltung nach Anspruch 2, dadurch gekennzeichnet, dass der Kollektor des ersten Transistors über einen Emitterfolger ($T_5$) mit einem ersten Spannungsteiler ($D_1$, $D_2$, $R_1$—$R_3$) gekoppelt ist, von dem ein erster Ausgang ($O_1$) wechselstrommässig mit der Basis des zweiten Transistors ($T_2$) verbunden ist und von dem ein zweiter Ausgang ($O_2$) mit der Basis des dritten Transistors ($T_3$) verbunden ist und dass ein zweiter Spannungsteiler ($D_3$, $D_4$, $R_5$—$R_6$) zwischen einer Speisespannung ($1/2\ V_B$) und Erde vorgesehen ist, wobei ein erster Ausgang ($O_3$) mit der Basis des ersten Transistors ($T_1$) und ein zweiter Ausgang ($O_4$) mit der Basis des vierten Transistors ($T_4$ verbunden ist.

**Revendications**

1. Circuit oscillateur comprenant un premier et un deuxième transistor ($T_1$, $T_2$), dont les émetteurs sont couplés l'un à l'autre et connecté conjointement au collecteur d'un troisième transistor ($T_3$), le premier transistor ($T_1$) étant connecté dans un montage à base commune fournissant une tension de circuit à un circuit résonnant parallèle (LC) couplé au collecteur du premier transistor ($T_1$), le collecteur étant couplé à la base du deuxième transistor ($T_2$) en vue d'une rétroaction positive de la tension de circuit, caractérisé en ce que le collecteur du premier transistor ($T_1$) est couplé en courant alternatif à la base du troisième transistor ($T_3$) en vue d'une rétroaction négative de la tension de circuit.

2. Circuit oscillateur suivant la revendication 1, caractérisé par un quatrième transistor ($T_4$), dont la base est connectée à une tension de polarisation de base fixe et dont l'émetteur est couplé à l'émetteur du troisième transistor ($T_3$), les deux émetteurs étant connectés conjointement à une source de courant constant, dont le courant aux tensions de polarisation du troisième et du quatrième transistor ($T_3$, $T_4$) traverse le troisième transistor ($T_3$) dans une mesure suffisssante pour amplifier la tension de circuit dans le premier transistor ($T_1$, de sortie qu'une réaction positive de la tension de circuit a lieu.

3. Circuit oscillateur suivant la revendication 2, caractérisé en ce que le collecteur de premier transistor est couplé, par l'intermédiaire d'un émetteur-suiveur ($T_5$), à un premier diviseur de tension ($D_1$, $D_2$, $R_1$—$R_3$), dont une première sortie ($O_1$) est connectée en courant alternatif à la base du deuxième transistor ($T_2$) et une seconde sortie ($O_2$) est connectée à la base du troisième transistor ($T_3$) et en ce qu'entre une tension d'alimentation ($\frac{1}{2}\ V_B$) et la masse est disposé un second diviseur de tension ($D_1$, $D_4$, $R_4$—$R_6$ dont une première sortie ($O_3$) est couplée à la base du premier transistor ($T_1$) et une seconde sortie ($O_4$), à la base du quatrième transistor ($T_4$).

FIG.1

FIG.2

FIG.3

2